# EUROPÄISCHE PATENTSCHRIFT

(11) **EP 0 834 242 B1**
(45) Veröffentlichungstag und Bekanntmachung des Hinweises auf die Patenterteilung: **03.04.2002**
(21) Anmeldenummer: 96919516.3
(22) Anmeldetag: 06.06.1996
(51) Int. Cl.: H05K 1/00, H05K 7/20, H01L 23/538

(54) **VERBINDUNGSSUBSTRAT**
CONNECTION SUBSTRATE
SUBSTRAT D'INTERCONNEXION

(30) Priorität: 15.06.1995 CH 176895
(43) Veröffentlichungstag der Anmeldung: 08.04.1998
(73) Patentinhaber: DYCONEX PATENTE AG, 6300 Zug (CH); ATOTECH Deutschland GmbH, 10553 Berlin (DE); Vantico AG, 4057 Basel (CH); FRAUNHOFER-GESELLSCHAFT ZUR FÖRDERUNG DER ANGEWANDTEN FORSCHUNG E.V., 80636 München (DE); Technische Universität Dresden, 01062 Dresden (DE)
(72) Erfinder: BARTE, Hans-Jürg, 77118 Wildberg-Sulz (DE); LOSERT, Ewald, 4133 Pratteln (CH); MEYER, Heinrich, 14109 Berlin (DE); RÖHRS, Günter, 01762 Obercardorf (DE); RUDOLF, Frank, 01776 Oberbärenburg (DE); SCHEEL, Wolfgang, 10178 Berlin (DE); SCHMIDT, Walter, 8050 Zürich (CH); ZUR NIEDEN, Theis, 71101 Schönaich (DE)
(74) Vertreter: Frei, Alexandra Sarah
(86) Internationale Anmeldenummer: CH9600218
(87) Internationale Veröffentlichungsnummer: WO9700598

(56) Entgegenhaltungen:
- EP-A- 0 197 516
- EP-A- 0 451 541
- EP-A- 0 632 685
- WO-A-93/26143
- WO-A-93/26146
- DE-A- 1 932 380
- US-A- 3 766 439
- US-A- 4 744 008
- US-A- 4 858 071
- IBM TECHNICAL DISCLOSURE BULLETIN, Bd. 36, Nr. 06A, Juni 1993, NEW YORK US, Seiten 333-334, XP000372450 "Composite card to provide uniform cooling to single chip modules with large Z tolerance"

## Beschreibung

Die Erfindung liegt auf dem Gebiet der Herstellung von Leiterplatten und betrifft insbesondere mehrlagige elektrische und optische Verbindungssubstrate mit Mehrfachfunktion und ein Verfahren zu deren Herstellung als ganzes oder zu deren Vor- und Zwischenprodukten.

Leiterplatten sind heutzutage immer komplexere elektro-mechanische und sogar opto-elektro-mechanische Mehrlagenstrukturen, bei deren Entwicklung und Herstellung eine Vielzahl Funktionen, die man in primäre und sekundäre Funktionen aufteilen kann, zu erfüllen sind.

Primäre Funktionen betreffen beispielsweise das Vorhandensein von Signalleitern zu den Komponenten sowie die Stromversorgung dieser Komponenten. Ferner betreffen sie die Bereitstellung einer mechanisch handhabbaren Trägerstruktur mit geeigneten Montageflächen für zu bestückende Komponenten und von genormten Schnittstellen zum Anschluss an andere Systemteile.

Sekundäre Funktionen beziehen sich beispielsweise auf die elektromagnetische Schirmung der Leiterplatte sowie auf die Integration passiver elektrischer Komponenten wie Widerstände, Kondensatoren, Induktivitäten, passive optische Komponenten wie Wellenleiter, Splitter, Combiner, Spiegel, usw. in das Verbindungssubstrat selbst. Sie betreffen mechanische Funktionen wie die Anpassung der Temperaturkoeffizienten der Trägerstruktur an die Komponenten. Zudem können auch flexible Verbindungselemente in das Verbindungssubstrat integriert werden. Sie beziehen sich ferner auf thermische Funktionen wie die passive bzw. aktive Kühlung und das Wärmemanagement, d.h. die Wärmeableitung bzw. die Wärmeverteilung.

Im folgenden werden einige Nachteile üblicher Mehrlagenstrukturen aus der Sicht primärer und sekundärer Funktionen dargelegt.

Undifferenzierte Vermischung der Funktionen: Heutzutage sind primäre und sekundäre Funktionen, wie sie oben aufgezählt wurden, in einer Einheit gleichsam "verschmolzen". Solch eine undifferenzierte Mehrlagenstruktur ist beispielsweise in den Schriften FR-2,117,172 und US-4,830,691 offenbart. In solchen Mehrlagenstrukturen sind Signalleiter und Stromversorgungsleiter in einem Dielektrikum eingebettet, das als mechanischer Träger dient. Lagen von Signalleitern und Stromversorgungsleitern verbinden Komponenten. Mehrere solcher Lagen werden über Durchplattierungen miteinander verbunden, die durch mehrere Ebenen hindurchführen. Nachteilig ist, dass die relativ langen und damit zwangsweise grosskalibrigen Durchgangslöcher durch die ganze Mehrlagenstruktur hindurch führen. Nachteilig ist auch, dass die Durchplattierungen oft elektrisch leitende Ebenen durchstossen müssen, was zusätzliche Vorkehrungen gegen Kurzschluss erforderlich macht.

Komplexität der undifferenzierten Vermischung: Die heutigen integrierten Schaltkreise sind bezüglich ihrer Funktionen zunehmend komplexer und werden in immer grösseren Zahlen auf Leiterplatten verwendet. Zudem steigen die Schaltfrequenzen an. Dies führt zu hochlagigen, dicht verdrahteten Mehrlagenstrukturen, welche gleichzeitig hohe Verlustleistungen abführen müssen. Dieser hohe Wärmeanfall erfordert zusätzliche wärmeleitende Elemente, deren thermische Durchkontaktierungen Verdrahtungsplatz wegnehmen, deren Layout die Komplexität der Mehrlagenstrukturen zusätzlich erhöht, was eventuell Kompatibilitätsprobleme mit sich bringt. Änderungen und Redesign können bei derart "verschmolzenen" Einheiten zu Projektverzögerungen führen. Nachteilig ist auch, dass innenliegende Verdrahtungsebenen der Mehrlagenstrukturen schwer oder gar nicht vortestbar sind, was das Risiko reduzierter Ausbeute birgt.

Miniaturisierung: Die Miniaturisierung ist nicht mehr nur auf kleinste Dimensionen von Leiterbahnenabständen in integrierten Schaltkreisen beschränkt, sondern gilt auch für die Geräte selbst. Taschen-Fernseher, tragbare Personal-Computer (Lap- bis Palmtop), Handkameras und andere hochkomplexe Geräte bedingen notwendigerweise klein dimensionierte Verbindungssubstrate. So ist es notwendig, die Form und Gestaltung von Verbindungssubstraten den Geräteformen anzupassen. Hierfür eignen sich flexible, insbesondere starrflexible Verbindungssubstrate mit Flex-Verbindern wie flexiblen Auslegern und flexiblen Schnittstellen. Bekanntermassen ist die Herstellung starr-flexibler Verbindungssubstrate nach herkömmlichen Verfahren aufwendig und teuer.

Wärmeabfuhr bzw. Kontrolle der Abwärme: Heutzutage erfolgt die Wärmeabfuhr in der Regel durch Einleitung über wärmeleitfähige Materialien in die Mehrlagenstruktur selbst. Solch eine wärmeableitende Mehrlagenstruktur ist beispielsweise in der Schrift EP-0,451,541 offenbart. Im Inneren der Mehrlagenstruktur wird die Wärme über wärmeleitende Materialien und über relativ grosse Distanzen an den Rand der Mehrlagenstruktur geführt. Um dieses thermische Problem zu lösen, bedarf es galvanischer Durchkontaktierungen, welche lediglich die Aufgabe haben, Wärme in das Verbindungsubstrat hinein bzw. wieder heraus zu führen.

Die Schrift US-4'744'008 bezieht sich auf eine elektronische Packung bestehend aus zwei elektronisch und mechanisch miteinander verbundenen Unterpackungen erster und zweiter Ordnung. Sie zeigt einen einfachen Aufbau mit sehr kurzen, direkten Verbindungen von Kapazitäten der ersten Unterpackung zu Chips der zweiten Unterpackung. Die erste Unterpackung ist ein flexibler Folienträger mit einseitig angebrachten Kapazitäten. Signalleitende- und stromversorgende Pfade sind ein-/beidseitig in Lagen auf einem dünnen Polyimidfilm des Folienträgers angelegt. Die zweite Unterpackung ist ein Starrträger, bspw. aus Keramik, der eine derartige Dicke besitzt, dass auf einer ersten Seite Vertiefungen für Chips anbringbar sind. Ferner sind auf der ersten Seite des Starrträgers Stromfade für die Signalübermittlung sowie für die Stromversorgung der Chips vorgesehen. Wärmeleiter reichen durch den Starrträger, um generierte Wärme auf dessen zweite Seite abzuführen.

Die Schrift EP-0'197'516 zeigt eine einlagige Leiterfolie, die mit Leiterzügen versehen und mit Bauelementen bestückt ist. Diese Leiterfolie ist durch Umhüllen mit aushärtendem Kunststaffschaum mit mechanischen Gehäuseteilstücken bestückt. Diese fertig montierte Leiterfolie ist an vorbestimmten Faltabschnitten zusammenfaltbar.

Die vorliegende Erfindung hat zur Aufgabe, eine Lösung zu suchen, mit welcher die Nachteile der zwangsläufig zunehmenden Komplexität heutiger Verbindungssubstrate grundsätzlich vermieden werden. Die Erfindung soll eine Mehrlagenstruktur mit hochdichten Verbindungsnetzen aufzeigen, die ein gutes Wärmemanagement ermöglicht, deren Komponenten über sehr kurze Signalleiter verbunden sind, deren (elektrische oder optische) Schaltung vortestbar ist, wobei starr-flexe Abschnitte mit verschiedenen Härten und Biegeradien einfach herstellbar sind. Es sollen dabei jedoch bekannte und bewährte Techniken, Materialien und dergleichen bevorzugt zur Anwendung kommen können. Beispielsweise sollen zur Herstellung der Leiterstrukturen bekannte nasschemische und ätzende Verfahren anwendbar sein. Die Weiterverarbeitung, insbesonders die Bestückung und die Kontaktierung soll mit bekannten Systemen, beispielsweise Löten, Wire-bonden etc. kompatibel sein.

Die vorliegende Aufgabe wird durch die in den unabhängigen Ansprüchen 1 und 8 definierte Erfindung gelöst. Besondere Ausführungsformen sind in den abhängigen Ansprüchen dargestellt.

Die erfindungsgemässe Idee basiert auf der funktionalen Analyse oder, mit anderen Worten, auf der Differenzierung eines funktionengetrennten Aufbauprinzipes von Funktionen wie "Stromversorgung", "Signalleiter", "mechanischer Träger", "Montageflächen", "Wärmesenken", "Flex-Verbinder" und "Schnittstellen zur Aussenwelt".

Diese Analyse zeigt, dass die beobachtete Komplexität heutiger Verbindungssubstrate sich im wesentlichen auf das Zusammenspiel zweier Charakteristika, nämlich auf das Zusammenspiel der funktionellen Komplexität mit der strukturellen Komplexität reduzieren lässt.

Die funktionelle Komplexität und die strukturelle Komplexität sind proportional zueinander und umfassen je drei Basiseigenschaften, welche elektrische und/oder optische Verbindungssubstrate zu erfüllen haben, nämlich signalvermittelnde, thermische und mechanische Eigenschaften. Je dichter die gewünschte signalvermittelnde funktionelle Komplexität (hoher Datendurchsatz) sein soll, desto höhere Anforderungen werden an die signalvermittelnde strukturelle Komplexität (Leiter- und Komponentendichte) des Verbindungssubstrates gestellt. Je höher die entstehende thermische funktionelle Komplexität (Wärmedichten und -gradienten), desto wirksamer muss die thermische strukturelle Komplexität (Thermolayout, Wärmesenken) der Verbindungssubstrate ausgelegt sein. Je höher die mechanische funktionelle Komplexität (Härten, Biegeradien und Versteifungen) als örtliche Funktion auf dem Verbindungssubstrate ist, desto höhere Anforderungen werden an die mechanische strukturelle Komplexität (Starr-Flex-Bereiche, örtliche Steifigkeit etc.) des Verbindungssubstrates gestellt.

Der hier herausgearbeitete proportionale Zusammenhang zwischen der funktionellen Komplexität und der strukturellen Komplexität, sowie der minimale Satz notwendiger Eigenschaften, hier der signalvermittelnden, der thermischen und der mechanischen Eigenschaften, umfasst und beschreibt vollständig die Funktionen zum Zwecke eines funktionengetrennten Aufbaus eines Verbindungssubstrates.

Die Aufgabenstellung der Erfindung lässt sich in der Sichtweise der funktionellen und der strukturellen Komplexität und ihrer Eigenschaften neu formulieren. In einer ersten Näherung werden signalvermittelnde, thermische und mechanische Eigenschaften der strukturellen Komplexität von herzustellenden Verbindungsubstraten in zwei räumlichen Strukturbereichen "innen" und "aussen" betrachtet:
- Die thermisch strukturelle Komplexität soll so ausgebildet sein, dass Wärme nicht nach innen, sondern nach aussen geleitet wird. Erste Vorgabe an Verbindungssubstrate ist: aussen "warm" und innen "kühl".
- Die signalvermittelnde strukturelle Komplexität soll nicht aussen, sondern im Inneren von Verbindungssubstraten ausgebildet sein, und sie soll über möglichst kurze Wege führen. Zweite Vorgabe an Verbindungssubstrate ist: innen "fein" und "dicht".
- Die mechanische strukturelle Komplexität soll über die gesamte Ausdehnung der Verbindungssubstrate verschieden gestaltbar sein. Die lokale Festigkeit lässt sich sowohl in inneren "feinen" und "dichten" als auch in äusseren Funktionsbereichen anlegen. Zum Erzielen einer grossen Variabilität unterschiedlicher mechanischer Eigenschaften, sollen äussere Strukturbereiche hohe Steifigkeiten und Festigkeiten aufweisen. Dritte Vorgabe an Verbindungssubstrate ist: aussen "starr", "grob" und innen "flexibel".

Es ist klar, dass die approximativen Strukturvorgaben gemäss Begriffen "warm", "kalt", "fein", "dicht", "starr", "grob", "flexibel" etc. im übertragenen Sinn verstanden werden müssen. "Fein" und "flexibel" heisst zum Beispiel feine Strukturen wie feinste Leiterbahnen auf flexiblen Folien, "grob" heisst zum Beispiel grobe Strukturen wie äussere Abmessungen von Komponenten, Abschirmungen, etc.

Der erfindungsgemässe Lösungsansatz besteht darin, zum Erzielen einer hohen strukturellen Komplexität und zum Erzielen einer hohen funktionellen Komplexität, die Funktionen wie "Stromversorgung", "Signalleiter", "mechanischer Träger", "Montageflächen", "Wärmeableitung", "Flex-Verbinder" und "Schnittstellen zur Aussenwelt" gemäss den approximativen Strukturvorgaben:
- innen: fein, dicht, flexibel und kühl.
- aussen: grob, starr und warm.
räumlich konsequent getrennten Funktionsbereichen zuzuordnen, sie ebenso konsequent getrennt zu optimieren und sie dann zu einem funktionengetrennten Strukturaufbau zu kombinieren. Dadurch erfolgt eine modular ausgestaltete Anordnung von Funktionsbereichen, die eine funktionenspezifische Optimierung und den Einsatz funktionsspezifischer Werkstoffe ermöglichen und die modular ausgestaltet in Strukturbereichen kombiniert werden. Dieses Vorgehen unterscheidet sich vom Stand der Technik durch die Vermeidung einer undifferenzierten Vermischung und "Verschmelzung" der Funktionen in Strukturbereichen.

Das erfindungsgemässe Herstellungsverfahren für Vor-, Zwischenprodukte und Verbindungssubstrate gemäss approximativen Vorgaben bildet modular gestaltete Funktionseinheiten und kombiniert sie in einem neuen Hierarchieverbund optimal. Hierzu wird beispielsweise ein spezieller, dieses erfindungsgemässe Funktionentrennungsverfahren berücksichtigender Designprozess angewendet, welcher die Strukturvorgaben unter Berücksichtigung gegenseitiger funktioneller Einflussgrössen in funktionengetrennten Strukturbereichen umsetzt:
- Den feinen, dichten, flexiblen und kühlen Innenbereichen wird ein flexibles Modul für "Signalleiter", zur "Stromversorgung", als "Flex-Verbinder" und als "Schnittstellen zur Aussenwelt" zugeordnet.
- Den groben, starren und warmen Aussenbereichen werden mechanische Versteifungselemente als "mechanische Träger" und als "Montageflächen", und es werden den groben, starren und warmen Aussenbereichen thermische Kühlelemente als "Wärmesenken" zugeordnet.

Solche derart funktionengetrennt hergestellten Vorprodukte, und Zwischenprodukte lassen sich an Flex-Verbinderstellen umbiegen und dadurch falten und/oder wickeln und kompakt machen, wodurch durch nachfolgende Versteifung mittels mechanischem Trägermaterial verfestigte Körper von Verbindungssubstraten entstehen. Die funktionengetrennte Kombination äussert sich beispielsweise in dem Vorteil, dass auf diese Weise zum Versteifen mechanisches Trägermaterial aus beispielsweise preisgünstigen Kunststoffmaterialien verwendbar ist, welches den relativ hohen Temperaturen bei vorhergehenden bzw. anderen Herstellungschritten, beispielsweise beim Assemblier-Verfahren, nicht ausgesetzt wird. Die Versteifung erfolgt gezielt und lokal, so dass sich die Vorprodukte, und Zwischenprodukte über nicht-versteifte Schnittstellenbereiche, die Teil des flexiblen Moduls sind, flexibel mit der Aussenwelt verbinden lassen.

Das erfindungsgemässe Vorgehen und beispielsweise hergestellte Vorprodukte, Zwischenprodukte und Verbindungssubstrate werden nun anhand der folgenden Figuren im Detail erläutert:
- **Fig. 1,2**: zeigen Teile typischer Ausführungsformen von Verbindungssubstraten gemäss dem Stand der Technik.
- **Fig. 3**: zeigt einen Teil einer beispielhaften Ausführungsform eines erfindungsgemäss hergestellten Verbindungssubstrates.
- **Fig. 4**: zeigt einen Teil einer beispielhaften Ausführungsform eines erfindungsgemäss hergestellten flexiblen Moduls (elektrische Verbindungen), das in weiteren Schritten zu einem vollständigen Verbindungssubstrat kombiniert wird.
- **Fig. 5(a),(b)**: zeigen Teile weiterer beispielhafter Ausführungsformen eines erfindungsgemäss hergestellten flexiblen Moduls (optische Verbindungen), das in weiteren Schritten zu einem vollständigen Verbindungssubstrat kombiniert wird.
- **Fig. 6**: zeigt einen Teil einer weiteren beispielhaften Ausführungsform eines erfindungsgemäss hergestellten flexiblen Moduls mit verschiedenen Ausführungsformen von Signalpfaden zwischen Komponenten, das in weiteren Schritten zu einem vollständigen Verbindungssubstrat kombiniert wird.
- **Fig. 7,8**: zeigen Teile weiterer beispielhafter Ausführungsformen erfindungsgemäss hergestellter flexiblen Moduls mit lokal in inneren Strukturbereichen realisierten Funktionen wie Flex-Verbinder.
- **Fig. 9**: zeigt einen Teil einer weiteren beispielhaften Ausführungsform eines erfindungsgemäss hergestellten Verbindungssubstrates mit lokal in äusseren Strukturbereichen realisierten Funktionen wie Wärmeableitung, Flex-Verbinder und Schnittstellen zur Aussenwelt über elektrische und/oder optische Sensoren.
- **Fig. 10-13**: zeigen Teile weiterer beispielhafter Ausführungsformen erfindungsgemäss hergestellter Verbindungssubstrate mit lokal in inneren Strukturbereichen realisierten Funktionen wie Flex-Verbinder und zum Teil gefaltet und versteift als kompakte Verbindungssubstrate.
- **Fig. 14,15**: zeigen Teile weiterer beispielhafter Ausführungsformen erfindungsgemäss hergestellter Verbindungssubstrate mit lokal in äusseren Strukturbereichen realisierten Funktionen wie Wärmeableitung und zum Teil gefaltet und versteift als kompakte Verbindungssubstrate.
- **Fig. 16**: zeigt einen Teil einer weiteren beispielhaften Ausführungsform eines erfindungsgemäss hergestellten Verbindungssubstrates oder stilisierten Laptops mit lokal in äusseren Strukturbereichen realisierten Funktionen wie mechanischer Träger, Wärmeableitung, Flex-Verbinder und Schnittstellen zur Aussenwelt, wobei der Versteifungsteil als Gehäuse ausgebildet ist.

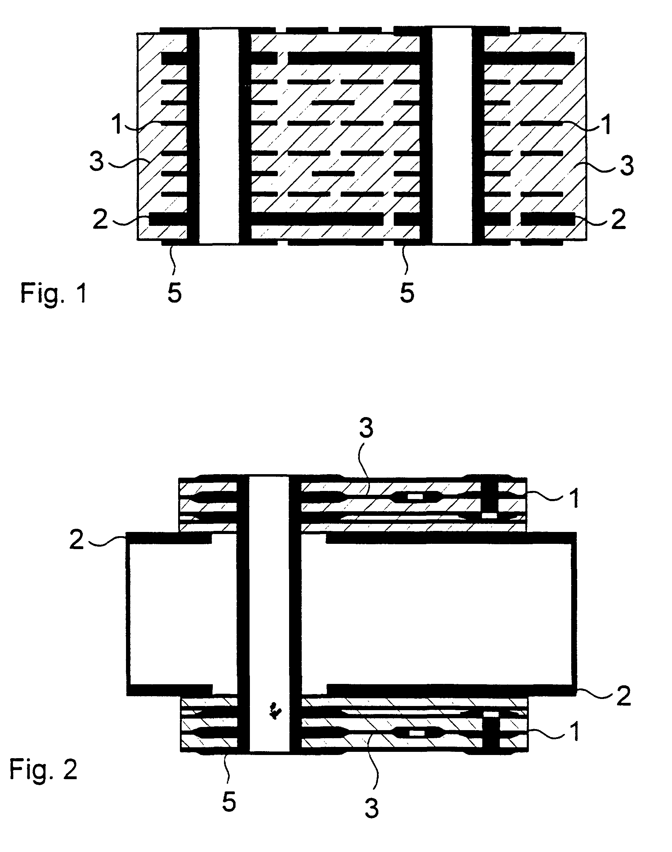

Zur Veranschaulichung der Erfindung zeigen die **Figuren 1 und 2** typische Ausführungsformen von Verbindungssubstraten mit in einem einheitlichen Strukturaufbau zu einer praktisch einzigen gemeinsamen Funktion verschmolzenen primären und sekundären Funktionen gemäss dem Stand der Technik. In der Mehrlagenstruktur gemäss Figur 1 sind Signalleiter 1 und Stromversorgungsleiter 2 in einem Dielektrikum 3 als mechanischer Träger ausgebildet. Lagen von dünnen Signalleitern 1 und dickeren Stromversorgungsleitern 2 verbinden Komponenten einer Ebene. Relativ lange und dicke Durchplattierungen oder Z-Leiter 5 führen durch die ganze Mehrlagenstruktur. In der Mehrlagenstruktur gemäss Figur Z erfolgt die Wärmeabfuhr und die Stromversorgung über einen inneren dicken Kern. Die Wärmeableitung der aussen bestückten Komponenten erfolgt ins Innere der Mehrlagenstruktur und heizt sie auf. Die Nachteile dieser Bauweise sind eingangs schon detailliert diskutiert worden.

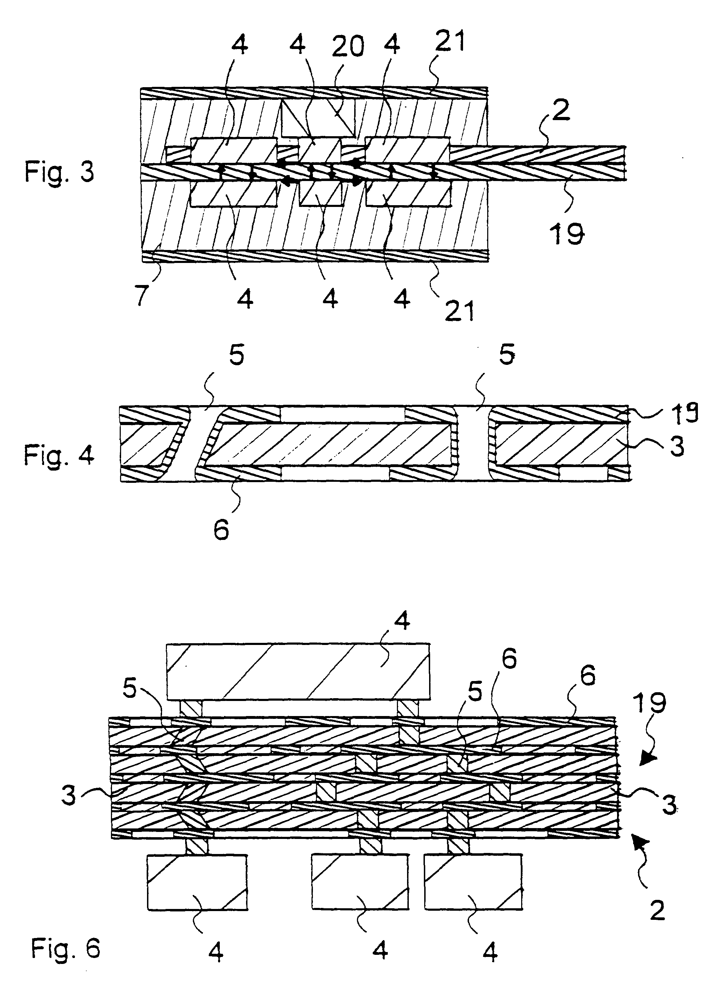

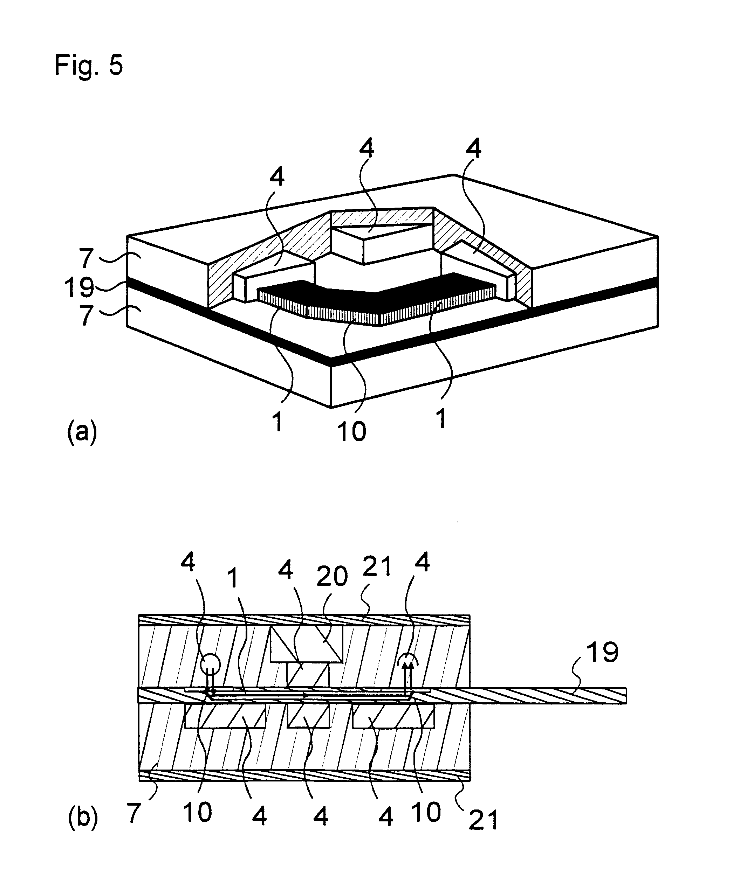

**Figur 3** zeigt im Schnitt schematisch einen Teil einer beispielsweisen Ausführungsform eines erfindungsgemäss hergestellten Verbindungssubstrates mit modular ausgestaltetem und funktionengetrenntem Strukturaufbau. Ein ähnlicher Aufbau mit optischen Mitteln wird in Figur 5 gezeigt. Die Funktionen "Signalleiter, "Stromversorgung", "Montageflächen", "mechanische Festigkeit", "Wärmesenken", "Flex-Verbinder", "Schnittstellen zur Aussenwelt" usw. sind beispielsweise in einem funktionengetrennten Designprozess realisiert und optimiert worden. In einem Hierarchieverbund werden die Funktionsbereiche gleichberechtigt in einem wechselseitigen Designprozess gemäss den Strukturvorgaben erarbeitet. Beispielsweise wird ein Signalverbindungsnetz mit bestückten Komponenten und Wärmesenken entworfen. Dieses kann über die Flex-Verbinder gefaltet und versteift werden. Diese Vorgänge werden einzeln überwacht und und bei funkionsspezifischen Fehlerwerten funktionsspezifisch getrennt optimiert. Werden beispielsweise nach einer Faltung zu hohe Temperaturen in bestimmten umgeklappten Verbindungssubstratbereichen gemessen, so wird in Abstimmung mit anderen Funktionen eine Korrektur erarbeitet. Diese Korrektur kann. sehr kompliziert sein, dementsprechend vielfältig sind die möglichen Korrekturlösungen. Beispielsweise werden signalvermittelnde Leitungen umgelenkt und die Komponenten an andere Bestückungsplätze gelegt, beispielsweise wird die Übertragung mechanischer Eigenschaften mittels Flex-Verbinder anders angelegt, sodass die Komponenten nach der Umbiegung/Faltung anders zueinander zu liegen kommen, beispielsweise wird lokal eine Wärmesenke eingebaut. Auf diese Weise wird das eingangs erwähnte Prinzip des funktionengetrennten Strukturaufbaus vollzogen und die Strukturvorgaben
- innen: fein, dicht, flexibel und kühl,
- aussen: grob, starr und warm
erfüllt. Die so entstehende Gesamtschaltung kann universell variiert werden, was in den folgenden Figuren ausgeführt wird.

Flexibles Modul: Ein flexibles Modul bildet das Innere der gemäss den approximativen Strukturvorgaben dicht und fein herzustellenden Verbindungssubstrate. Durch Optimierung des signalvermittelnden Funktionsbereichs "Signalleiter" wird ein flexibles Modul mit Signalleitern 19 höchst verdichtet und somit sehr nahe an die Anschlüsse der Komponenten 4 herangebracht. Ein solches Herstellungsverfahren ist beispielsweise das DY-COstrate®-Verfahren der Anmelderin, wie beispielsweise in den Schriften WO92/15408 und WO93/26143 offenbart. Teile beispielhafter Ausführungsformen von elektrischen und/oder optischen flexiblen Modulen sind in den Figuren 4 und 5 abgebildet und werden in der Beschreibung dieser Figuren im Detail erläutert Das flexible Modul wird in separaten Verfahrensschritten hergestellt und ist separat vortestbar, d.h. es ist in sehr frühen Herstellungsstadien testbar, bevor eine Kombination mit anderen Funktionseinheiten erfolgt, wodurch die Ausschussrate von Verbindungssubstraten drastisch verringert wird. Das flexible Modul kann bestückt oder unbestückt in Rolle zu Rolle-Verfahren hergestellt und zwischengelagert werden und ist somit ein Vorprodukt.

Stromversorgung: Die elektrische Energieversorgung ist ist meist dem signalvermittelnden Substratteil zugeordnet, kann aber prinzipiell auch funktional abgetrennt und separat optimiert werden. Stromversorgsleiter 2 sind auch im Vergleich zu den Signalleitern 19 grob strukturiert und lassen sich beispielsweise parallel oder zusammen mit dem flexiblen Modul als signalverbindender Substratteil herstellen. Ein solches Herstellungsverfahren ist beispielsweise das DYCOstrate®-Verfahren der Anmelderin, wie beispielsweise in den Schriften WO92/15408 und WO93/26143 offenbart. Auch hier gilt, dass die Stromversorgung zwischenlagerbar und somit ein Vorprodukt ist und nach ihrer Realisierung zur frühzeitigen Fehlerdetektion und Ausschussverminderung vortestbar ist. Etwaige Korrekturen lassen sich ebenso rasch und einfach durchführen, da die elektrische Stromversorgung in diesem Herstellungsstadium noch nicht mit ändern Funktionseinheiten, beispielsweise von versteitenden Trägermaterial verdeckt ist.

Montageplätze: Auf dem flächigen flexiblen Modul werden Komponenten 4 an Bestückungsplätzen ein und/oder beidseitig bestückt. Alle drei Dimensionen, die Fläche mit XY-Leitern und die Dicke mit Z-Leitern werden somit für ein optimales Routing ausgenutzt. Die totale Dicke des flexiblen Moduls ist gering, beispielsweise unterhalb 500 µm, die Komponenten 4 sind in optimalen, kürzesten Abständen zueinander angeordnet, sodass die Signalleiter 19 zwischen den Komponenten 4 möglichst kurz, d.h. beispielsweise in dieser Grössenordnung der Schaltungsdicke verlaufen. Je kürzer die Signalleiter 19 sind, desto einfacher die Realisierung des Entwurfes, desto schneller ist die Übertragung und desto geringer sind die Störungseinflüsse. Diese kurzen Signalleiter 19 sind schematisch als gerichtete Pfeile zwischen den Komponenten 4 gekennzeichnet. Die Komponenten 4 sind beispielsweise unverpackte integrierte Schaltkreise oder verpackte SMD-Bausteine, die mittels geeigneter Methoden wie Löten, Kleben, Wire-Bonden oder TAB-Bonden mit dem flexiblen Modul elektrisch verbunden werden. Die Komponenten 4 können beispielsweise auch passive elektrische und/oder optische Komponenten 4 wie Widerstände, Kondensatoren, Induktivitäten, nachkontaktierbare Schaltungskomponenten, Wellenleiter, Splitter, Combiner, Spiegel, usw. sein. Solche passiven Komponenten 4 können aber auch im Inneren des flexiblen Moduls realisiert sein.

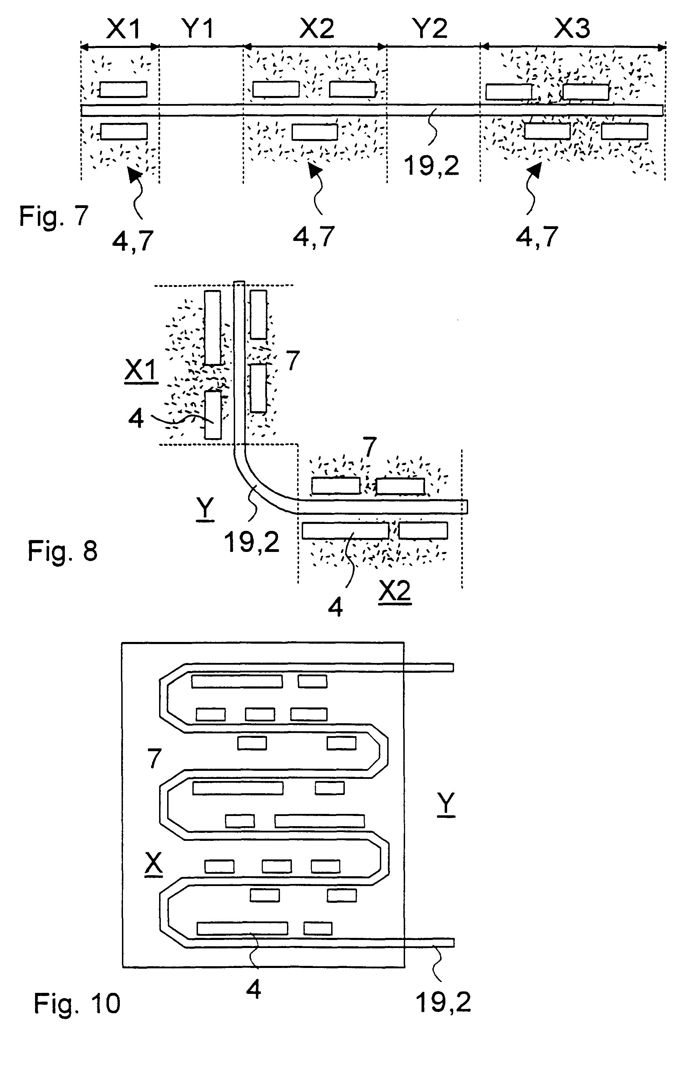

Mechanische Festigkeit: Die mechanische Festigkeit wird separat von den anderen Funktionen hergestellt und demgemäss separat optimiert. Um das dünne, mit Komponenten 4 bestückte flexible Modul wird in separaten Herstellungsschritten ein versteifendes Substratteil 7 realisiert, wodurch lokal gezielt eine leicht einstellbare Versteifung zu einem zwischenlagerbaren Zwischenprodukt erfolgt. Teile beispielhafter Ausführungsformen versteifender Substratteile 7 für Verbindungssubstrate sind in den Figuren 7 bis 16 abgebildet und werden in der Beschreibung dieser Figuren im Detail erläutert. Bereiche die mit versteitenden Substratteilen 7 bedeckt sind, sind härter und steifer, solche, die nicht bedeckt werden, sind weicher und flexibel. Um eine grosse Variabilität unterschiedlicher mechanischer Eigenschaften zu einzuarbeiten, wird die Steifigkeit gemäss den approximativen Strukturvorgaben in äusseren Strukturbereichen realisiert.

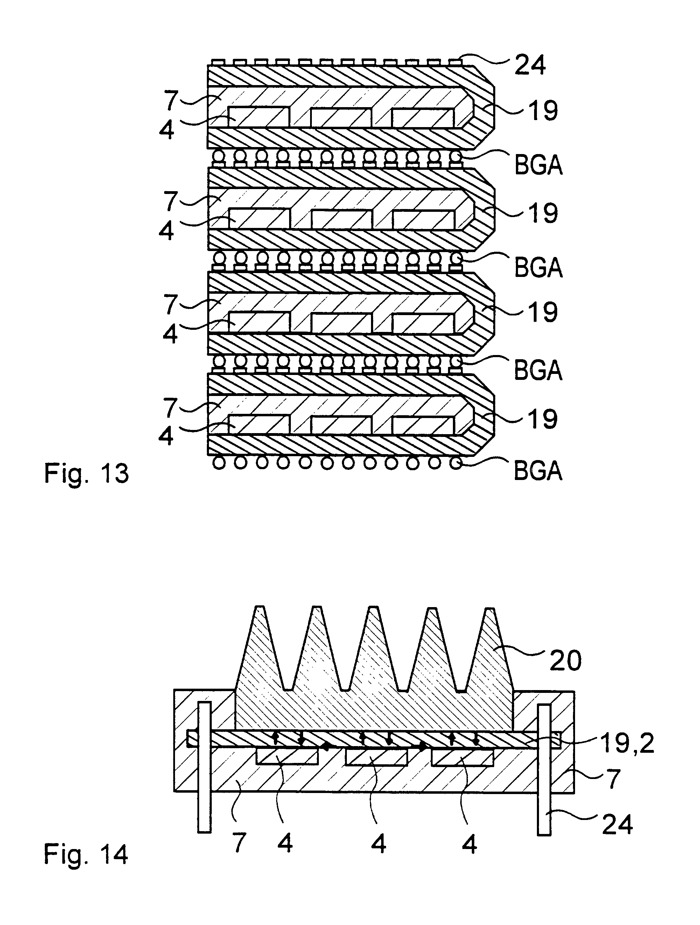

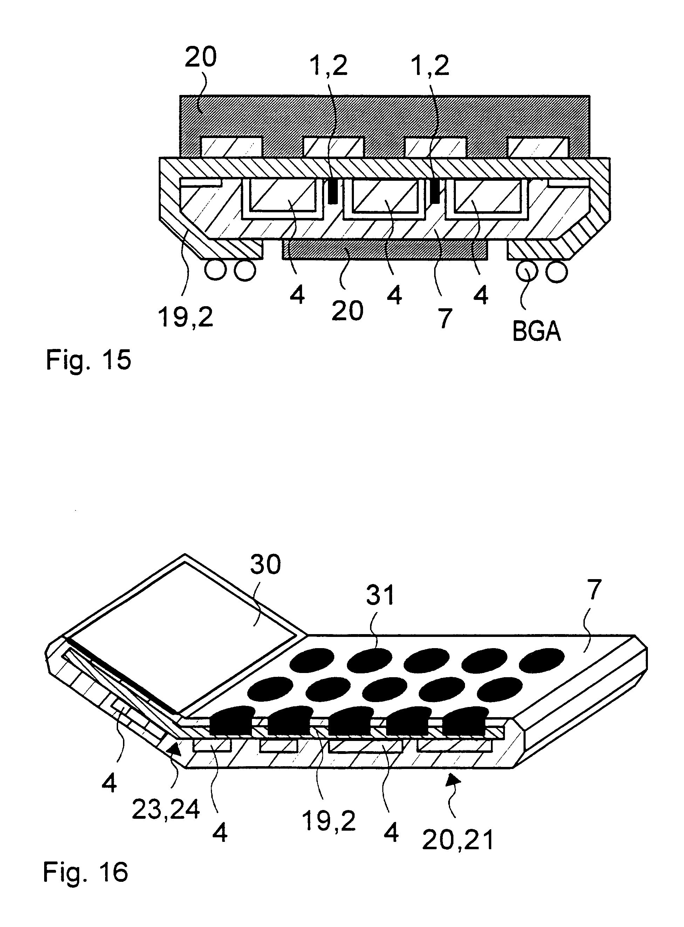

Wärmesenken: Um das dünne, mit Komponenten 4 bestückte flexible Modul wird in separaten Herstellungsschritten ein Thermo-Management realisiert, wodurch die von aktiven Bausteinen generierte Wärme gezielt und lokal nach aussen geleitet und dort dissipiert wird. Die approximativen Strukturvorgaben innen "kühl", aussen "warm" werden somit realisiert. Solch ein beispielhaftes Thermolayout ist in den Figuren 14 und 15 abgebildet und wird in der Beschreibung dieser Figuren im Detail erläutert. Aufgrund der geringen Dicke und Masse nehmen die Signalleiter sowie die Stromversorgung geringe Wärmemengen auf. Spezielle, an Wärmequellen angebrachte Wärmesenken 20 leiten die Wärme lokal an aussen angebrachte Thermoleiter oder Kühlkörper 21, wo sie dissipiert wird.

Flex-Verbinder: Mit versteifenden Substratteilen 7 unbedeckte Strukturbereiche des Verbindungssubstrates dienen aufgrund ihrer vergleichsweise höheren Flexiblität als flexible Ausleger und lassen sich in vielfältiger Weise verwenden. Die Verbindungssubstrate lassen sich durch die Anlage von starr-flexiblen Strukturbereichen umbiegen und so falten und/oder wickeln, wodurch nach Versteifung umgebogene Zonen kompakter Verbindungssubstrate entstehen. Beispielhafte Ausführungsformen solcher Flex-Verbinder sind in den den Figuren 7 bis 16 gezeigt und in den Beschreibungen dieser Figuren im Detail erläutert.

Schnittstellen zur Aussenwelt: Unabhängig ob flexible signalverbindende Strukturbereiche oder ob Komponenten 4 mit versteifenden Substratteilen 7 bedeckt oder unbedeckt sind, lassen sich Signalleitende Substratteile 19 des Verbindungssubstrates in vielfältiger Weise als Schnittstellen zur Aussenwelt einsetzen. Beispielhafte Ausführungsformen von Schnittstellen zur Aussenwelt sind gemäss den Figuren 7 bis 16 abgebildet und in der Beschreibung dieser Figuren im Detail erläutert. So bilden die nichtverstärkten flexiblen Signalleitende Substratteile 19, beispielsweise biegsame, verbindbare Schnittstellen zur Montage des Verbindungssubstrates in einem Gerätegehäuse und zum Erstellen von elektrischen, optischen und mechanischen Verbindungen, beispielsweise über zu Steckern versteiften Enden solch signalLeitender Substratteile 19, oder beispielsweise über optische Koppler als integrierte oder bestückte Komponente, oder beispielsweise als Abschirmung, Sender oder Antenne. Zur Herstellung solcher Konturen im Verbindungsubstrat eignet sich beispielsweise das DYCOstrate®-Verfahren der Anmelderin, wie in der Schrift PCT/CH94/00092 offenbart. Dem Fachmann stehen bei Kenntnis der vorliegenden Erfindung vielfältige Möglichkeiten der Variation solcher Schnittstellen zur Aussenwelt zur Verfügung.

**Figur 4** zeigt einen Teil einer beispielhaften Ausführungsform eines im erfindungsgemässen Verfahren hergestellten flexiblen Moduls in mehrlagigem Leit- und Isolatormaterial, welche in bekannten nasschemischen Ätz-Verfahren und/oder in bekannten Plasma-Ätz-Verfahren strukturiert ist. Ein bekanntes Strukturierungsverfahren ist das DYCOstrate®-Verfahren der Anmelderin, das beispielsweise in den Schriften WO92/15408 und WO93/26143 offenbart ist. Die Materialien, die verwendet werden, sind einfach, kostengünstig und funktionenoptimiert. Zur Verwendung kommen dünne mit Metall beschichtete Folien, beispielsweise mit dünner Kupferfolie (3 bis 70 µm dick) beschichtete dünne Polyimid-Folien, Liquid Crystal Polymere oder Epoxydharz-Folien (12 bis 100 µm dick). Beispielsweise wird als Ausgangsmaterial eine dreischichtige Folie mit zwei äusseren Schichten Leitmaterial verwendet, die durch eine intermediäre Schicht Isolatormaterial voneinander isoliert sind. In den beiden Leitschichten wird ein Verdrahtungsbild mit XY-Leitern herausgeätzt. Durch die intermediäre Isolatorschicht wird ein Verdrahtungsbild von Signalleitern 19 mit in den Schichten Leitmaterial strukturierten XY-Leitern 6 und mit schrägen oder senkrechten Z-Leitern 5 herausgeätzt, wie beispielsweise in der europäischen Druckschrift EP-0575292 der Anmelderin offenbart. Bei den Ätzverfahren für die Z-Leiter schützen Abdeckschichten diejenigen Teile, welche nicht weggeätzt werden sollen. Die Abdeckschichten können Metallschichten, Schichten von Photoresist oder wieder entfernbare abdeckenden Metallschichten sein, wie beispielsweise in der Schrift PCT/CH94/00134 der Anmelderin offenbart. Auf diese Weise wird ein dreidimensionales flexibles Modul mit Signalleitern 19 unterschieden in XY-Leitern 6 und Z-Leitern 5 und getrennt durch ein Dielektrikum 3 gebildet. Im oder am flexiblen Modul sind eine oder mehrere Schichten einer eletrischen Stromversorgung realisiert. Vorteilhafterweise werden 4-lagige oder 6-lagige Substratteile mit zwei oder mehr inneren Lagen Signalleitern 19 (X,Y - und Z-Leitern) und mit ein oder zwei äusseren Lagen Speiseleitern 2 einer Stromversorgung realisert.

Um bei hochfrequenten Anwendungen unerwünschte Effekte, wie bspw. hohe Dämpfungen, Reflexionen oder Übersprechen von Signalen zu verhindern, ist es notwendig, nicht nur die Abstände, sondern auch die Breiten der signalvermittelnden Leiter in bestimmten engen Grössenbeziehungen zu gestalten. Die gleichmässigen Dielektrikumsdicken, die kleinen Dämpfungswerte und Dielektrizitätskonstanten und auch die engen Toleranzbreiten der Dielektrizitätskonstanten der verwendeten Folien in X, Y und Z-Richtung eignen sich hervorragend für diese Erfordernisse. Die vorliegende Erfindung führt demgemäss zu Schaltungen, die aufgrund der dünnen Metall- und Nichtmetallschichten (jeweils 12 bis 150 µm dick) und den kleinen Durchplattierungen (Durchmesser kleiner 100 µm, Längen kleiner 500 µm) hervorragend für Anwendungen im Hochfrequenzbereich geeignet sind. Dies ist von grosser technischer Bedeutung, weil die Tendenz dahingeht, dass beispielsweise zukünftige Personal Computers nicht nur im zentralen Rechenprogramm sehr hoch (mehrere Hundert Mega-Hertz) getaktet arbeiten, sondern dass auch für das Bussystem auf den Verbindungssubstraten diese Taktfrequenzen angestrebt wird. Mit gängigen, funktionenverschmolzenen Verbindungssubstraten ist dies aufgrund der makroskopischen Dimensionen von Lagendicken und Leiterbreiten, wie auch aufgrund der wechselnden Zusammensetzung und wechselnden Dicke des Dielektrikums aus Glasfasergewebe und der wechselnden Dicke der Matrix aus Epoxyd- oder Polyimid-Harz, schwerlich möglich.

**Figur 5** zeigt einen Ausschnitt aus einer weiteren beispielsweisen Ausführungsform eines flexiblen Moduls mit optischen Mitteln, das zu einem Verbindungssubstrat kombiniert ist. Figur 5(a) ist eine perspektivische Ansicht des Ausschnittes, bei welchem das versteifende Substratteil 7 teilweise entfernt gezeichnet ist, damit die von der tragenden Struktur umhüllten Elemente zum Vorschein kommen; Figur 5(b) ist ein Querschnitt durch ein solches flexibles Modul. Die technischen Merkmale gemäss Figur 5 basieren weitgehend auf denjenigen gemäss den vorhergehenden Figuren 3 und 4, sodass diese nicht wiederholt beschrieben werden. Im Unterscheid zur Figur 4 sind gemäss Figur 5 ein beispielsweiser optischer Signalleiter 19 mit einem Wellenleiter 1 und mit optischen Lenkmitteln 10 wie Spiegel, Combiner oder Splitter im flexiblen Modul realisiert. Auch sind aktive und passive optische Komponenten 4 wie Laser, LED, Detektoren oder Opto-Koppler im Verbindungssubstrat selbst integriert. Auf diese Weise lassen sich optisch leitende Durchkontaktierungen von der Aussenwelt über Komponenten 4 und Lenkmittel 10 zu Wellenleitern 1 bewerkstelligen, sodass ein Senden/Empfangen breitbandiger optischer Signale möglich wird und optische Signale vermittelnd werden. Optische und elektrische Komponenten vermitteln Signale über das opto-elektrische flexible Modul. Auch hier gilt, dass möglichst kurze Entfernungen zwischen den optischen und elektrischen Komponenten 4 realisiert werden und dass das dreidimensionale opto-elektrische flexible Modul vortestbar und zwischenlagerbar ist.

**Figur 6** zeigt in schemathcher Darstellung einen Teil einer weiteren Ausführungsform eines nach dem erfindungsgemässen Verfahren hergestellten flexible Modul mit verschiedenen Ausführungsformen von Signalpfaden 5,6 zwischen Komponenten 4. Unter Bezugnahme auf die Beschreibung gemäss Figur 4 wird ein mehrlagiges flexibles Modul, beispielsweise aus vier Lagen Signalleitenden Leiterbahnen 19 gemäss Figur 4, strukturiert und mit Komponenten 4 bestückt. Die Komponenten 4 sind beispielsweise stoffschlüssig gelötet, mikrogeschweisst (drahtgebondet), leitgeklebt oder mittels alternativer Verbindungstechnologien an das flexible Modul kontaktiert. In mehreren Leitschichten, die durch Isolatorschichten 3 voneinander isoliert sind, wird ein flexibles Modul mit XY-Leitern 6 und mit schräg oder senkrecht dazu verlaufenden Z-Leitern 5 herausgeätzt. Das ganze flexible Modul ist bei Verwendung des oben beschriebenen dünnen Folienmaterials beispielsweise dünner als 500 µm und vor der modularen Kombination mit anderen Funktionsteilen vortestbar und zwischenlagerbar.

Einzelne Z-Leiter 5 verbinden immer zwei strukturierte Leitschichten, welche durch eine einzelne strukturierte Isolatorschicht 3 separiert sind. Das gesamte flexible Modul weist Pfade elektrisch miteinander verbundener Z-Leiter 5 durch Isolator- und Leitschichten auf. Je nach Strukturierung dieser Pfade, beispielsweise je nach Länge dieser Pfade, sind mehr oder weniger unterschiedliche strukturierte Leitschichten elektrisch miteinander verbunden. Im Spezialfall reichen die Pfade von Z-Leitern durch das gesamte flexible Modul und erlauben die elektrische Verbindung von auf verschiedenen Seiten an Bestückungsplätzen bestückten Komponenten 4 des flexiblen Moduls. Gemäss Figur 6 sind zwei Ausführungsformen solcher Z-Leiterpfade zur Signalübertragung zwischen verschiedenseitig bestückten Komponenten 4 durch das gesamte flexible Modul ausgebildet. Auf der linken Seite der Figur 6 sind beispielsweise alternierende, schräge Z-Leiter 5 angeordnet, auf der rechten Seite der Figur 6 sind zueinander versetzt verlaufende senkrechte Z-Leiter 5 angeordnet. Die schrägen Z-Leiter 5 verbinden zwei Komponenten 4 miteinander. Die zueinander versetzt verlaufenden Z-Leiter 5 teilen sich und laufen parallel zueinander versetzt durch das flexible Modul. Sie verbinden beispielsweise drei Komponenten 4 miteinander, eine auf der Oberseite des flexiblen Moduls gemäss Figur 6 mit zwei Komponenten 4 auf der Unterseite des flexiblen Moduls. Dem Fachmann stehen bei Kenntnis der vorliegenden Erfindung natürlich die Realisierung weitere Ausführungsformen wie beispielsweise Kombinationen senkrechter und schräger Z-Leiter frei.

Die **Figuren 7** und **8** zeigen Teile weiterer beispielhafter Ausführungsformen erfindungsgemäss hergestellter flexibler Module mit lokal in inneren Strukturbereichen realisierten Funktionen wie Flex-Verbinder. Die Auslegung der mechanischen Eigenschaften findet in funktionengetrennter Weise statt. Auf einem flexiblen Modul werden Komponenten 4 wie integrierte Schaltungen etc. als Starrelemente angeordnet. Wesentlich ist im mechanischen Funktionsbereich, dass die Starrelemente und/oder mit versteifenden Substratteilen 7 versteiften Funktionsbereiche weniger flexibel als die Signalleitenden und/oder stromversorgende Leiterbahnen 19,2 selbst bis sogar starr sind.

Auf diese Weise kann die mechanische Komplexität eines Verbindungssubstrates beliebig angelegt werden. Ein Beispiel zeigt Figur 7, bei welcher, schematisch dargestellt, starre Bereiche X1, X2, X3 usf. erzeugt werden, welche jeweils durch Flexbereiche Y1,Y2 voneinander getrennt sind. Ein weiteres Beispiel zeigt Figur 8, bei der Signalleitende und/oder stromversorgende Leiterbahnen 19,2 in einem Flexbereich Y beispielsweise um einen Winkel von 90° umgelegt ist. Solche Anordnungen lassen sich beispielsweise spiralförmig zu einer Rolle aufwickeln. Mit anderen Starr/Flex-Anlagen kann man Stapel, Leporellos und andere Faltungen bzw. Umbiegungen erzielen, dies in funktionengetrennter Weise. Die signalvermittelnden und thermischen Anforderungen werden separat entwickelt, wobei jedoch jeder Schritt stets von den beiden anderen Funktionbereichen überwacht, bewertet und bei Abweichung von der vorgegebenen funktionengetrennten Norm eine Änderung veranlasst wird.

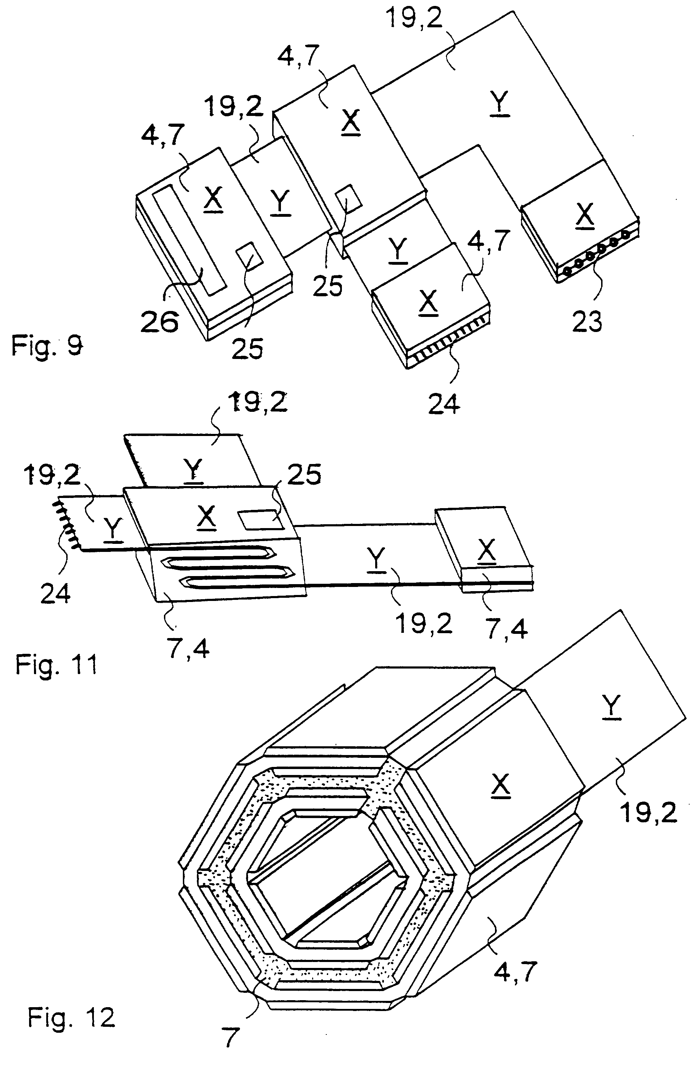

**Figur 9** zeigt einen Teil einer weiteren beispielhaften Ausführungsform eines erfindungsgemäss hergestellten Verbindungssubstrates mit lokal in äusseren Strukturbereichen realisierten Funktionen wie Wärmeableitung, Flex-Verbinder und Schnittstellen zur Aussenwelt.

Die Versteifung mit versteifenden Substratteilen 7 findet gezielt lokal statt. Diese Versteifung erfolgt beispielsweise an umgebogenen oder gefalteten flexiblen Modulen gemäss den Figuren 8 bis 13 und stellt eine Überlagerung mechanischer Komplexitäten in Starr/Flex-Bereichen dar. Eine erste mechanische Komplexität betrifft die gezielte Faltung gemäss flexiblen Bereichen, eine weitere mechanische Komplexität betrifft die gezielte Versteifung dieses Faltproduktes. Die Flexibilität, die Biegeradien der Flex-Bereiche sowie die Härten der Versteifung sind als als örtliche Funktionen gezielt lokal und in sukzessiven. Herstellungsschritten mit unterschiedlichen funktionsspezifischen Werkstoffen zu optimieren. Die Flex-Bereiche sind beispielsweise flexible Folien des inneren Strukturbereiches; sie sind mehr oder weniger mit Komponenten, Starrelementen oder aufgebrachten Versteifungsmitteln vorversteift. Die definitive Versteifung in Starr-Bereiche erfolgt durch spezielle funktionsspezifische Versteifungsmittel. Als Versteifungsmittel lassen sich bekannte handelsübliche stoffschlüssige, formschlüssige und kraftschlüssige Mittel wie gespritzter Kunststoff, übergezogener Schrumpfschlauch, aufgetragene Aushärtpasten, Klebfolien, etc, verwenden. Dem Fachmann stehen hierbei bei Kenntnis der vorliegenden Erfindung vielfältige Möglichkeiten zur Verfügung.

Unabhängig ob flexible Signalleitende Substratteile 19 oder ob Komponenten 4 mit versteifenden Substratteilen 7 bedeckt oder unbedeckt sind, lassen sich Signalleitende Substratteile 19 des Verbindungssubstrates in vielfältiger Weise als Schnittstellen zur Aussenwelt einsetzen. So bilden die nichtverstärkten flexiblen Signalleitenden und/oder stromversorgenden Substratteile 19,2 beispielsweise biegsam verbindbare Schnittstellen zur Montage des Verbindungssubstrates in einem Gerätegehäuse und zum Erstellen von elektrischen, optischen und mechanischen Verbindungen, beispielsweise über zu Steckern 23,24 versteifte Enden solch Signalleitenden und/oder stromversorgender Substratteile 19,2. Beispielsweise können Schnittstellen zur Aussenwelt auch über optische Fenster 25, die in das Trägermaterial eingebracht werden können, hergestellt werden. Zudem sind lokal auch elektromagnetische Abschirmungen 26 und/oder Schnittstellen wie Sende- oder Empfangsantennen denkbar. Dem Fachmann stehen bei Kenntnis der vorliegenden Erfindung vielfältige Möglichkeiten der Variation solcher Schnittstellen zur Aussenwelt zur Verfügung.

Die **Figuren 10** bis **13** zeigen schematisch Teile weiterer beispielhafter Ausführungsformen erfindungsgemäss hergestellter Verbindungssubstrate mit lokal in inneren Strukturbereichen realisierten Funktionen wie Flex-Verbinder und zum Teil umgebogen und versteift als gefaltete Verbindungssubstrate. Die technischen Merkmale gemäss den Figuen 10 bis 13 basieren weitgehend auf denjenigen gemäss der vorhergehenden Figur 9, sodass diese nicht wiederholt beschrieben werden. Im Unterscheid zur Figur 9 sind gemäss den Figuren 10 bis 13 beispielhafte Faltungen von flexiblen Modulen gezeigt, wodurch der Platzverbrauch dieser Verbindungssubstrate reduziert wird. Die einer solchen Faltung entspringenden Vorteile liegen auf der Hand. Es können wesentlich mehr Bauteile pro Volumeneinheit verdrahtet werden. Solch eine Faltung ist nur durch den erfindungsgemässen, konsequent funktionengetrennten Strukturaufbau der Verbindungssubstrate möglich.

Figur 10 zeigt eine schlangenförmige Faltung eines beispielsweise beidseitig mit Komponenten 4 bestückten flexiblen Moduls und die Versteifung dieser Faltung als Starr-Bereich X durch ein versteifendes Substratteil 7. Aus der Versteifung X herausragende Signalleitenden und/oder stromversorgenden Substratteile 19,2 dienen beispielsweise als Schnittstellen zur Aussenwelt in Form von Flex-Bereichen Y.

Figur 11 zeigt eine ähnliche Ausführungsform einer schlangenförmigen Faltung als Teil eines Verbindungssubstrates mit Starr/Flex-Bereichen gemäss der Beschreibung zu Figur 9.

Figur 12 zeigt eine Ausführungsform als gewickelte Gesamtschaltung, wo zwei Verbindungssubstrate mit unterschiedlichen Biegeradien beispielsweise übereinander gewickelt und mechanisch versteift werden. Die aus der Versteifung X herausragen Signalleitenden und/oder stromversorgende Substratteile 19,2 dienen beispielsweise als Schnittstellen zur Aussenwelt in Form von Flex-Bereichen Y.

Figur 13 zeigt eine Ausführungsform als übereinandergelegte Gesamtschaltung, wo mehrere mehr oder weniger identische Verbindungssubstrate übereinander gelegt und durch ein elektrische Verbindungsmittel in Form kleiner Lötkugeln (ball grid array, BGA) oder anisotroper Leitkleber signalverbindend und mechanisch versteifend miteinander verbunden werden.

Die **Figuren 14** und **15** zeigen Teile weiterer beispielhafter Ausführungsformen erfindungsgemäss hergestellter Verbindungssubstrate mit lokal in äusseren Strukturbereichen realisierten Funktionen wie Wärmeableitung und zum Teil gefaltet und versteift als kompakte Verbindungssubstrate. Die Wärmeleitung wird in Anlehnung an das in der Schrift PCT/CH93/00148 der Anmelderin offenbarte Thermo-Layout in das Verbindungssubstrat integriert und mittels Thermokonduktoren und Wärmesammel-Elementen realisiert. Die charakteristischen Grössen sind dann in Anlehnung an die Layout-Symbolik die Wärmeaufnahme-Kapazität von Wärmesammlern (ähnlich Kondensatoren, Kapazitäten), die Wärmeleit-Kapazität von Thermoleitern (ähnlich elektrischen Leitern), die Wärmeabstrahl-Kapazität von Wärmeradiatoren (Strahlung, Konvektion, ähnlich Induktivitäten), die Wärmequellen (ähnlich Spannungsquellen) und die Wärmesenken (ähnlich Massen). Auf einem Verbindungssubstrat befinden sich meist mehrere Wärmequellen, das sind die aktiven Bausteine, gut angelegte Wärmekondensatoren und Wärmeleiter, dort wo es möglich ist, Abstrahler (Kühlkörper) und Wärmesenken massiverer Bauart. Eine grobe modellmässige Annäherung ist ohne weiteres möglich.

Die Figuren 14 und 15 zeigen beispielsweise Realisierungen von Wärmesenken 20, die von Wärmekonduktoren angelaufen werden und die Wärme in die Senke abführen. Die Wärmesenken können in einem oberen Teil als Strahler, im mittleren Teil als Speicher und im unteren Teil als Wärmeüberleiter ausgestaltet sein. Die beispielsweise von Komponenten 4 generierte Wärme wird gezielt und lokal nach aussen abtransportiert.

**Figur 16** zeigt einen Teil eines erfindungsgemäss hergestellten Verbindungssubstrates in der beispielhaften Ausführungsform eines stilisierten Laptops; an diesem Beispiel soll gezeigt werden, wie das mechanische Verbindungssubstratteil als getrennt geplantes, getrennt optimiertes und getrennt hergestelltes Modul ein Gerätegehäuseteil oder ein Gerätegehäuse ist. Beim Aufbau und beim Verbinden der Module zu der das Verbindungssubstrat verkörpernden Gesamtschaltung bildet das Gerätegehäuse ein versteifendes Substratteil 7 aussen starr, und im innern sind die signalleitenden Substratteile 19, innen flexibel und dicht, und komponententragendenden Substratteile mit den Komponenten 4 angeordnet. Die Wärmeleitenden Substratteile 20,21 leiten Wärme nach aussen, hier in den Bodenteil des Gehäuses. Die Schnittstellen zum Display 30 und zur Tastatur 31 sind von aussen nicht sichtbar.

Gemäss Erfindung kann ein Gerät dergestalt geplant und realisiert werden, dass der Aufbau des Verbindungssubstrates funktionengetrennt erfolgt, indem signalleitende Substratteile 19 bzw. stromversorgende Substratteile 2, Wärmeleitende Substratteile 20,21, versteifende Substratteile 7 (hier das Gehäuse) sowie die Anordnung der Komponenten 4 bzw. komponententragende Substratteile als interdependente Funktionen bzw. Module getrennt geplant, getrennt optimiert, getrennt hergestellt und schliesslich räumlich getrennten Funktionsbereichen (innen flexibel/aussen starr) der Gesamtschaltung (hier dem Gerät) zugeordnet werden, wobei der Aufbau durch Verbinden der Module zu einer das Verbindungssubstrat verkörpernden Gesamtschaltung (hier zu einem Gerät) erfolgt.

Ein zu einem Gerät gestaltetes mehrschichtiges Verbindungssubstrat mit Leitungsnetzwerk, Komponenten und versteifenden Substratteilen im wesentlichen in Form eines Gehäuses ist folgendermassen aufgebaut:
- Die Substratteile mit den feinen, dichten, flexiblen Elementen sind den inneren Bereichen der Gesamtschaltung bzw. des Gerätes zugeordnet,
- die Substratteile mit den starren Elementen und/oder Komponenten sind den äusseren Bereichen der Gesamtschaltung bzw. des Gerätes zugeordnet,
- versteifende Substratteile sind im äusseren Bereich so angelegt, dass der Schaltung eine mechanische Trägerstruktur verliehen wird, welche Trägerstruktur lokal starr und in flexible Bereiche übergehend gestaltet ist und als Gehäuse gestaltet sein kann,
- wobei die Gesamtschaltung entsprechend den starren und flexiblen Abschnitten gefaltet und/oder gewickelt sein kann, Schnittstellen aufweist und ein eingestalteter Teil des Gesamtgerätes ist.

Das Verfahren zur Herstellung von mehrschichtigen Verbindungssubstraten mit Mehrfachfunktion besteht zusammengefasst darin, dass der Aufbau des Verbindungssubstrates funktionengetrennt erfolgt, indem Substratteile mit signalleitenden Leiterbahnen 19, und stromversorgenden Leiterbahnen 2, versteitende Substratteile 7, sowie die Anordnung der Komponenten 4 bzw. komponententragenden Substratteile als interdependente Funktionen bzw. Module getrennt geplant, getrennt optimiert und schliesslich räumlich getrennten Funktionsbereichen (innen/aussen) der Gesamtschaltung zugeordnet werden, wobei der Aufbau durch Verbinden der Module zu einer das Verbindungssubstrat verkörpernden Gesamtschaltung erfolgt. Das so entstandene mehrschichtige Verbindungssubstrat mit Leitungsnetzwerk, Komponenten 4 und versteifenden Substratteilen 7 ist folgendermassen aufgebaut: Die Substratteile mit den feinen, dichten, flexiblen Elementen sind den inneren Bereichen der Gesamtschaltung zugeordnet, die Substratteile mit den starren Elementen und/oder Komponenten sind den äusseren Bereichen der Gesamtschaltung zugeordnet, und ein versteifendes Substratteil 7 ist im äusseren Bereich so angelegt, dass der Schaltung eine mechanische Trägerstruktur verliehen wird, welche Trägerstruktur lokal starr und in flexible Bereiche übergehend gestaltet ist, wobei die Gesamtschaltung entsprechend den starren und flexiblen Abschnitten gefaltet und/oder gewickelt sein kann.

## Patentansprüche

1. Verfahren zur Herstellung eines modular aufgebauten, mehrschichtigen Verbindungssubstrates mit elektrischen und/oder optischen Mehrfachfunktionen mit den Schritten:
dass ein flexibles Modul, bestehend aus einem oder mehreren Substratteilen mit signalleitenden und/oder stromversorgenden Leiterbahnen (19,2) hergestellt wird,
dass dieses flexible Modul auf einer oder beiden Seiten mit elektrischen und/oder optischen Komponenten (4) bestückt wird,
dass dieses flexible Modul an mindestens zwei Aussenflächen mindestens teilweise in der Weise mit versteifenden Substratteilen (7) versehen wird, daß dem flexiblen Modul eine mechanische Trägerstruktur verliehen wird, wobei die versteifenden Substratteile (7) mit wärmeabgebenden bzw. wärmeleitenden Substratteilen (20,21) verbunden und/oder mindestens teilweise durch diese gebildet werden.

2. Verfahren nach Anspruch 1, **dadurch gekennzeichnet, dass** versteifende Substratteile (7) mit wärmeabgebenden- bzw. wärmeleitenden Substratteilen (20,21) so verbunden werden, dass das flexible Modul mindestens teilweise umschlossen ist.

3. Verfahren nach Anspruch 1 oder 2, **dadurch gekennzeichnet, dass** das mit Komponenten (4) bestückte flexible Modul flächendeckend mit Wärme in Aussenbereiche transportierenden thermischen Substratteilen (20) verbunden wird.

4. Verfahren nach Anspruch 1, **dadurch gekennzeichnet, dass** signalleitende- und/oder stromversorgende Leiterbahnen (19,2) in einer oder mehreren Lagen angeordnet werden, diese Leiterbahnen elektrisch miteinander verbunden werden und Anschlussstellen zu den Komponenten (4) vorgesehen werden.

5. Verfahren nach Anspruch 1, **dadurch gekennzeichnet, dass** die versteifenden Substratteile (7) über ihre räumliche Ausdehnung mit verschiedenen Festigkeiten gefertigt werden.

6. Verfahren nach Anspruch 1 oder 5, **dadurch gekennzeichnet, dass** Komponenten (4) und/oder wärmeleitende Substratteile (20) in versteifende Substratteile (7) integriert werden.

7. Verfahren nach Anspruch 1 oder 6, **dadurch gekennzeichnet, dass** lokale versteifende Substratteile (7) am flexiblen Modul im wesentlichen starre bzw. im wesentlichen biegfähige Abschnitte schaffen, über welche eine oder mehrere Faltung/en eines gesamten Verbindungssubstrates ermöglicht wird.

8. Mehrschichtiges Verbindungssubstrat mit elektrischen und/oder optischen Mehrfachfunktionen mit folgendem Aufbau:
ein flexibles Modul, welches aus einem oder mehreren Substratteilen mit signalleitenden und/oder stromversorgenden Leiterbahnen (19,2) besteht,
auf einer oder beiden Seiten mit elektrisch und/oder optischen Komponenten (4) bestückt ist und
an mindestens zwei Aussenflächen mindestens teilweise in der Weise mit versteifenden Substratteilen (7) versehen ist, dass dem flexiblen Modul eine mechanische Trägerstruktur verliehen wird, wobei die versteifenden Substratteile (7) mit wärmeabgebenden bzw. wärmeleitenden Substratteilen (20,21) verbunden und/oder mindestens teilweise durch diese gebildet sind.

9. Mehrschichtiges Verbindungssubstrat nach Anspruch 8, **dadurch gekennzeichnet, dass** wärmeleitende Substratteile (20) in versteifende Substratteile (7) integriert sind.

10. Mehrschichtiges Verbindungssubstrat nach Anspruch 9, **dadurch gekennzeichnet, dass** die versteifenden Substratteile (7) entsprechend den starren und flexiblen Bereichen gefaltet und/oder gewickelt sind.

11. Mehrschichtiges Verbindungssubstrat nach Anspruch 10, **dadurch gekennzeichnet, dass** die flexiblen Bereiche der versteifenden Substratteile (7) gebogen sind, so dass starre Teile des Verbindungssubstrates Bereiche eines kompakten Körpers bilden.

12. Mehrschichtiges Verbindungssubstrat nach einem der Ansprüche 8 bis 11, **dadurch gekennzeichnet, dass** Substratteile mit signalleitenden- und/oder stromversorgenden Leiterbahnen (19,2) in inneren Schichten XY-Leiter aufweisen und dass sie in Ebenen zu diesen inneren Schichten Z-Leiter aufweisen und testbar sind.

13. Mehrschichtiges Verbindungssubstrat nach einem der Ansprüche 8 bis 12, **dadurch gekennzeichnet, dass** versteifende Substratteile (7) dem Verbindungssubstrat eine starre oder flexible Trägerstruktur verleihen und aus einem umhüllenden Kunststoff bzw. einer Schrumpffolie bestehen.

14. Mehrschichtiges Verbindungssubstrat nach Anspruch 13, **dadurch gekennzeichnet, dass** die versteifenden Substratteile (7) durch einen getrennt hergestellten Gerätegehäuseteil oder durch das Gerätegehäuse gebildet sind.

## Claims

1. Method for the manufacture of a modularly designed multilayer connecting substrate with electrical and/or optical multiple functions, comprising the steps of:
manufacturing a flexible module consisting of one or several signal conducting and/or power supplying conductor paths (19, 2),
equipping this flexible module on one or on both sides with electrical and/or optical components (4),
providing this flexible module, on at least two outer areas, at least partly with stiffening substrate parts (7) in a manner such that the flexible module is given a mechanical carrier structure, wherein the stiffening substrate parts (7) are connected to heat emitting or heat conducting substrate parts (20, 21) respectively and/or are at least partly formed by these.

2. Method according to claim 1, **characterized in that** stiffening substrate parts (7) are connected to heat emitting or heat conducting substrate parts (20, 21) respectively in such a manner that that the flexible module is at least partly enclosed.

3. Method according to claim 1 or 2, **characterized in that** the flexible module (4) equipped with components (4) is connected, in an area covering manner, to thermal substrate parts (20) which conduct heat to outer areas..

4. Method according to claim 1, **characterized in that** the signal conducting and/or power supplying conductor paths (19, 2) are arranged in one or more layers, that these conductor paths are interconnected and connection points to the components (4) are provided.

5. Method according to claim 1, **characterized in that** the stiffening substrate parts or (7) are manufactured with different strengths over their spatial extension.

6. Method according to claim 1 or 5, **characterized in that** components (4) and/or heat conducting substrate parts (20) are integrated into stiffening substrate parts (7).

7. Method according to claim 1 or 6, **characterized in that** local stiffening substrate parts (7) create substantially rigid or substantially bendable sections respectively on the flexible module which permit one or more folds of an overall connecting substrate.

8. Multilayer connecting substrate with electrical and/or optical multi-functions with the following construction:
a flexible module which consists of one or several substrate parts with signal conducting and/or power supplying conductor paths (19, 2),
the module being equipped, on one or on both sides, with electrical and/or optical components (4) and
on at least two outer surfaces is equipped with stiffening substrate parts (7) in a manner that the flexible module is given a mechanical carrier structure, wherein the stiffening substrate parts (7) are interconnected with heat emitting or heat conducting substrate parts (20, 21) and/or are at least partly formed by these.

9. Multilayer connecting substrate according to claim 8, **characterized in that** the heat conducting substrate parts (20) are integrated into stiffening substrate parts (7).

10. Multilayer connecting substrate according to claim 9, **characterized in that** the stiffening substrate parts (7) are folded and/or wound in accordance with the rigid and flexible regions.

11. Multilayer connecting substrate according to claim 10, **characterized in that** the flexible areas of the stiffening substrate parts (7) are bent, such that the rigid parts of the connecting substrate form layers of a compact body.

12. Multilayer connecting substrate according to one of claims 8 to 11, **characterized in that** the substrate parts with signal conducting and/or power supplying conductor paths (19, 2) comprise XY-conductors in inner layers and that they comprise Z-conductors in planes to these inner layers and are testable.

13. Multilayer connecting substrate according to one of claims 8 to 12, **characterized in that** the stiffening substrate parts (7) give the connecting a rigid or flexible carrier structure and consist of an enveloping plastic or shrink film respectively.

14. Multilayer connecting substrate according to claim 13, **characterized in that** the stiffening substrate parts (7) are formed by a separately manufactured apparatus housing part or by the apparatus housing.

## Revendications

1. Procédé de préparation d'un support de liaison à plusieurs couches, de structure modulaire, à multiples fonctions électriques et/ou optiques, comportant les étapes par lesquelles :
on prépare un module flexible constitué d'une ou de plusieurs parties de support avec des pistes conductrices (19, 2) conduisant des signaux et/ou d'alimentation en courant,
ce module flexible est équipé d'un ou des deux côtés de composants (4) électriques et/ou optiques,
sur au moins deux surfaces extérieures, ce module flexible est doté au moins en partie de parties de support (7) de renforcement, de telle sorte qu'une structure porteuse mécanique soit conférée au module flexible, les parties de support (7) de renforcement étant reliées à des parties de support (20, 21) dissipant 1a chaleur ou conduisant la chaleur et/ou étant formées au moins en partie par celles-ci.

2. Procédé selon la revendication 1, **caractérisé en ce que** des parties de support (7) de renforcement sont reliées à des parties de support (20, 21) dissipant la chaleur ou conduisant la chaleur, de telle sorte que le module flexible soit au moins en partie englobé.

3. Procédé selon la revendication 1 ou 2, **caractérisé en ce que** le module flexible équipé de composants (4) est relié d'une manière qui recouvre sa surface à des parties thermiques de support (20) transportant la chaleur dans la région extérieure.

4. Procédé selon la revendication 1, **caractérisé en ce que** des pistes conductrices (19, 2) conduisant des signaux et/ou d'alimentation en courant sont disposées en une ou plusieurs couches, ces pistes conductrices étant reliées électriquement les unes aux autres et des emplacements de raccordement aux composants (4) étant prévus.

5. Procédé selon la revendication 1, **caractérisé en ce que** les parties de support (7) de renforcement sont fabriquées avec différentes résistances mécaniques dans leur extension spatiale.

6. Procédé selon la revendication 1 ou 5, **caractérisé en ce que** les composants (4) et/ou des parties de support (20) conduisant la chaleur sont intégrés dans les parties de support (7) de renforcement.

7. Procédé selon la revendication 1 ou 6, **caractérisé en ce que** des parties de support (7) de renforcement local créent sur le module flexible des parties essentiellement rigides ou essentiellement flexibles par l'intermédiaire desquelles un ou plusieurs plis d'un support de liaison complet sont possibles.

8. Support de liaison en plusieurs couches à multiples fonctions électriques et/ou optiques, présentant la structure suivante :
un module flexible constitué d'une ou plusieurs parties de support présentant des pistes conductrices (19, 2) conduisant les signaux et/ou d'alimentation en courant,
équipé sur un ou sur les deux côtés de composants (4) électriques et/ou optiques, et qui
sur au moins deux surfaces extérieures, est doté au moins en partie de parties de support (7) de renforcement de telle sorte qu'une structure porteuse mécanique soit conférée au module flexible, les parties de support (7) de renforcement étant reliées à des parties de support (20, 21) dissipant la chaleur ou conduisant la chaleur et/ou étant formées au moins en partie par cette dernière.

9. Support de liaison en plusieurs couches selon la revendication 8, **caractérisé en ce que** des parties de support (20) conduisant la chaleur sont intégrées dans les parties de support (7) de renforcement.

10. Support de liaison en plusieurs couches selon la revendication 9, **caractérisé en ce que** les parties de support (7) de renforcement sont repliées et/ou enroulées en correspondance aux régions rigides et aux régions flexibles.

11. Support de liaison en plusieurs couches selon la revendication 10, **caractérisé en ce que** les régions flexibles des parties de support (7) de renforcement sont courbées de telle sorte que des parties rigides du support de liaison forment des régions d'un corps compact.

12. Support de liaison en plusieurs couches selon l'une des revendications 8 à 11, **caractérisée en ce que** les parties de support présentant des pistes conductrices (19, 2) conduisant des signaux et/ou d'alimentation en courant présentent des conducteurs XY dans les couches intérieures et des conducteurs Z dans les plans conduisant à ces couches intérieures, et **en ce qu'**elles peuvent être testées.

13. Support de liaison en plusieurs couches selon l'une des revendications 8 à 12, **caractérisé en ce que** les parties de support (7) de renforcement confèrent au support de liaison une structure porteuse rigide ou flexible et sont constituées d'une matière synthétique d'enveloppe ou d'une feuille rétractable.

14. Support de liaison en plusieurs couches selon le revendication 13, **caractérisé en ce que** les parties de support (7) de renforcement sont formées par une partie de boîtier d'appareil fabriquée séparément ou par le boîtier d'appareil.
